Europäisches Patentamt

European Patent Office

Office européen des brevets

(11) Publication number: **0 082 561**
**B1**

# EUROPEAN PATENT SPECIFICATION

(45) Date of publication of patent specification: **19.03.86**

(21) Application number: **82201587.1**

(22) Date of filing: **10.12.82**

(51) Int. Cl.⁴: **G 03 G 15/01**

(54) Method for the formation of a multicolour proof print starting from at least two colour separations and device for performing this method.

(30) Priority: **16.12.81 NL 8105675**

(43) Date of publication of application:
**29.06.83 Bulletin 83/26**

(45) Publication of the grant of the patent:
**19.03.86 Bulletin 86/12**

(84) Designated Contracting States:
**AT BE CH DE FR GB IT LI LU NL SE**

(56) References cited:
**EP-A-0 038 050**
**US-A-3 836 244**
**US-A-3 999 987**
**US-A-4 120 577**

(73) Proprietor: **COULTER STORK PATENTS B.V.**
**62 Oostenburgermiddenstraat**
**NL-1018 MS Amsterdam (NL)**

(72) Inventor: **Percic, Milan**
**13 D. Boutstraat**
**NL-5831 VN Boxmeer (NL)**

(74) Representative: **Timmers, Cornelis Herman Johannes et al**
**EXTERPATENT Willem Witsenplein 4**
**NL-2596 BK 's-Gravenhage (NL)**

Courier Press, Leamington Spa, England.

## Description

The invention relates to a method for forming a multi-colour proof print starting from at least two (light-transmitting) colour separations, wherein a charge pattern is formed from each colour separation by exposure of a photoconductive coating which has been charged previously to a certain charge state, this charge pattern being developed a predetermined period after the charge state has been achieved using toner of a colour corresponding to the colour separation concerned, the toner image thus obtained being transferred onto a receptor surface in such a way that the second and subsequent toner images are in registration with the preceding one(s).

In multi-colour printing, as is already known, use is made of colour separations, i.e. of partial images in each of the three basic colours (yellow, magenta, cyanogen) and usually supplemented with a partial image in black. Different techniques are known for obtaining these colour separations, starting from the original to be reproduced and naturally before starting the final production printing run a check must be made that a good final result is obtained with the colour separations formed.

For this purpose normally a proof print is made on a proof printing press, which is a time-consuming operation. Furthermore the proof printing press required is expensive.

An electrophotographic method as indicated above is known from EP—A2—0 038 050.

In said application an apparatus and method are described for producing colour-proofs from colour separations. The method is carried out in an apparatus which is capable to accommodate one photoconductive coating with which, via an electrophotographic process comprising the steps of electrostatic charging, contacting with a colour separation film, exposure, film removal and toner transfer, toner images are formed on a substrate.

Repeating said process a number of times, the number being equal to the number of separations corresponding to the total image, a complete multi-colour proof on the substrate· is obtained, provided the right colour-toners are used.

This known process however has the disadvantage of being lengthy; a complete 4-colour proof takes four times the time needed fora single colour.

The graphics industry, being very speed dependent, needs a process which takes as little time as possible; therefore such a known process is not as attractive as it should be. A further drawback of the known process is the repeated use, in relatively short cycles, of the photoconductor.

Generally, photoconductive materials after charging and discharging need a certain recovery time; if this time is not given a fatigue effect may occur which influences the reproducibility of the system.

The present invention aims at providing a method for forming a multi-colour proof print which can be executed rapidly and cheaply and which provides a result which corresponds so well with a print formed on a printing press that it is possible to make a good assessment of the colour separations and which has a good reproducibility.

The method according to the invention is characterized in that use is made of at least two photoconductive coatings with identical characteristics and for each of the toner images a photoconductive coating is charged up to a final charge state and development with toner starts after a period of time after the coating has achieved the final charge state which period and final charge state are identical for all toner images.

The present invention is based on the insight that fully reproducible and comparable results are obtained if, starting from a final charge state for the electrophotographic coating which is identical for all partial images, the development of the respective partial images starts at an indentical point on the darkness decay curve of the corresponding coating which in fact is essentially the commencement of development after a period which is identical for all partial images after the final charge state has been achieved. In actual practice it has been observed that results are obtained which closely match those obtained with a proof print.

Naturally it is much cheaper to construct a device for performing this method than a proof printing machine, so that the method proposed in accordance with the invention can also be used by small firms.

The charging of the coating is preferably undertaken during a period which is identical for all the respective toner partial images, the same .as the development by applying toner.

These measures facilitate the execution of the method in accordance with the invention. Preferably, furthermore the respective charging and development periods are mutually identical.

Preferably several coatings having mutually identical characteristics are used for the forma-·tion of the respective partial images, whereby preferably the charging of a photoconductive coating is undertaken during the period of development of a coating which prior to this has already been charged up and exposed with a partial image of a different colour.

When preparing a series of proof prints from the same originals the exposures for a certain colour separation are preferably effected with equal light quantities throughout the series, when using coatings sensitive to glare phenomena.

When effecting the method of the invention with certain types of photoconducting coatings, such as zincoxide coatings, the quality of the toner image is improved when the coating is moistened with a toner dispersant prior to the application of toner.

To obtain good results it is advantageous when, after the transfer of the toner to the receptor surface and prior to the further charging of the photoconductive coating, the surface thereof is moistened with a suitable solvent and the applied solvent is then sucked off.

Any residual charge on the photoconductive coating will flow away when after the transfer of the toner to the receptor surface and prior to the further charging the photoconductive coating is uniformly exposed. As a result the respective consecutive images all possess high quality.

The quality is still better when, prior to the transfer of toner, the receptor surface is moistened and dried after toner transfer.

A device used for execution of the method in accordance with the invention comprises a housing which accommodates a flat support for a photoconductive coating, means to form a charge pattern from a colour separation by exposure of said coating charged previously, means to develop the charge pattern a predetermined period after the charge state has been achieved using a tone of a colour corresponding to the colour separation concerned, means to transfer the toner image thus obtained onto a receptor surface in such a way that the second and subsequent toner images are in registration with the preceding one(s), which device is characterised in that means are provided to accommodate at least two photoconductive coatings having identical characteristics, that means are provided to charge up each of the photoconductive coatings for each of the toner images to a final charge state and to start development with toner after a period of time after the coatings have achieved the final charge state which period and final state are identical for all toner images.

This procedure results in a compact construction and the movement of the constituent parts described with respect to each other can be achieved by simple guides and controls.

A preferred embodiment of this device is such that the support can be moved around a fixed axis parallel with the surface from an initial position, in which the coating can be charged and exposed, to a second postion which is rotated through 180° with respect thereto, in which the exposed surface can be provided with toner from one of the toner holders located one above the other in a magazine, which for this purpose can, by means of a drive mechanism be brought out of the magazine into a path which extends along the support and back into the magazine.

Preferably the device is such that the support carries a photoconductive coating on both surfaces, the support being horizontal in the two positions, the charging and exposure means being located above the level of the support shaft, and the toner and image transfer means being located thereunder.

The horizontal location of the support with the photoconductive coatings and the arrangement described above of the means interacting therewith contributes to a compact construction and especially facilitates the supply of toner to the exposed photoconductive coating.

In a favourable embodiment each toner holder is closed at the top by a flat plate having at least two slots located transverse to the direction of movement of the holder, the level of which coincides with that of the outer surface of a toner transport roller mounted in the holder, which roller can be driven in rotary fashion in a direction opposed to the direction of movement of the holder, toner being applied by the roller to the plate from the holder during this rotation.

Preferably here the plate is electrically isolated with respect to the support and, in order to function as developing electrode, can be brought to a certain electrical potential with respect to the support. Satisfactory and uniform application of the toner is facilitated if the rollers can be displaced over a short distance transverse to the axial direction thereof.

A further embodiment of the invention comprises a doctor blade which, at least at the end of the toner application movements, carries out the cleaning of the flat top plate of the toner holder.

It is favourable if the toner which still remains behind on the photoconductive coating after image transfer is removed; for this purpose use can be made of one or several solvent discharge and suction nozzles having the discharge aperture facing upwards, covering the width of the coating, which are accommodated in an essentially horizontal direction in a frame which can move to and fro underneath the coating.

However use should be made preferably of a holder for solvent which can move to and fro in a horizontal direction underneath the coating and one or several application rolls which project over a short distance from the upper confine thereof, which are driven in rotary fashion and connected with a narrow overflow chamber which passes over the photoconductive coating and which is open at the top, connected to a solvent feed pipe, accommodated in and projecting from a holder provided with a liquid outlet, possibly combined with a suction nozzle which passes over the photoconductive coating.

The invention will now be discussed with the aid of the drawings.

Fig. 1 shows a schematic frontal view of the mutual position of the different constituent parts of the arrangement in accordance with the invention;

Fig. 2 provides a view in the direction of the arrow 2;

Fig. 3 provides a view in the direction of the arrow 3;

Fig. 4a—4e show the positions and movements of the different constituent components with respect to each other;

Fig. 5 is a schematic side view, partially in section, of a toner holder employed in accordance with the invention;

Fig. 6 is a schematic section of an arrangement for applying an accurately predetermined quantity of toner solvent to the photoconductive coating;

Fig. 7 is a perspective representation of a part of the arrangement in accordance with the invention;

Fig. 8 illustrates the left-hand portion of this arrangement;

Fig. 9 gives a perspective view of the right-hand portion of this arrangement.

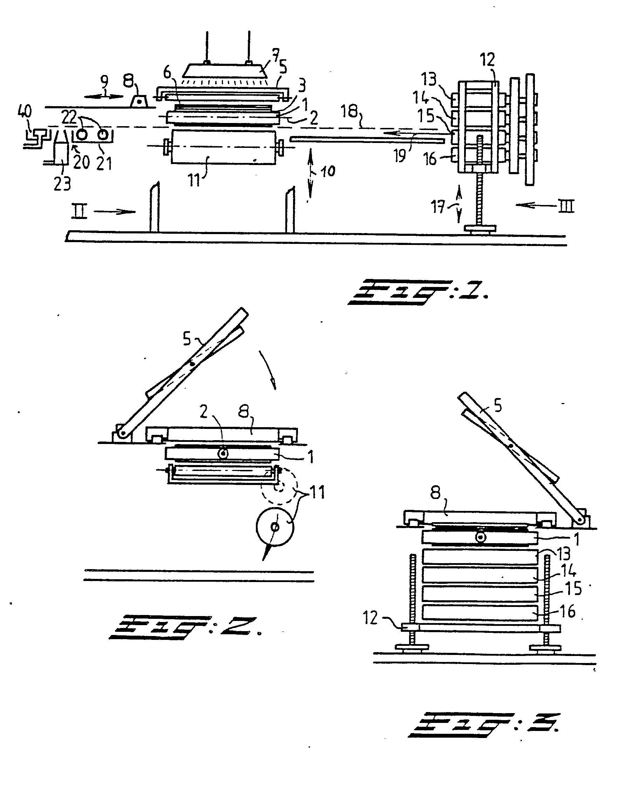

In fig. 1—3 the various constituent parts of the device are indicated only very schematically. The frame accommodating the components is not shown, neither are the various drives and controls. The diagrams serve exclusively to illustrate the mutual position and to indicate the motion of the components with respect to each other.

The device consists of a flat support 1, shown in frontal view in fig. 1, which can rotate around the shaft 2 which is located in the plane of the drawing; the surface of the support 1 is thus vertical to the plane of the drawing. On each of the large surfaces the support 1 is provided with a photoconductive coating, indicated by the reference numerals 3 and 4 respectively.

Both coatings possess the same characteristic properties. Above the support there is a pressure frame 5 for pressing a light-transmitting colour separation 6, from which a proof print must ultimately be made, firmly against the coating 3.

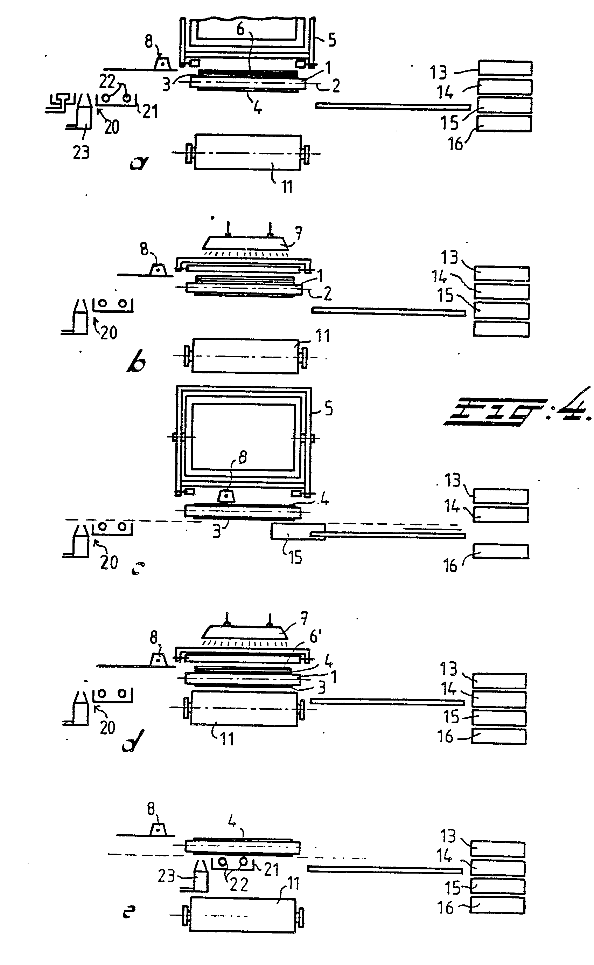

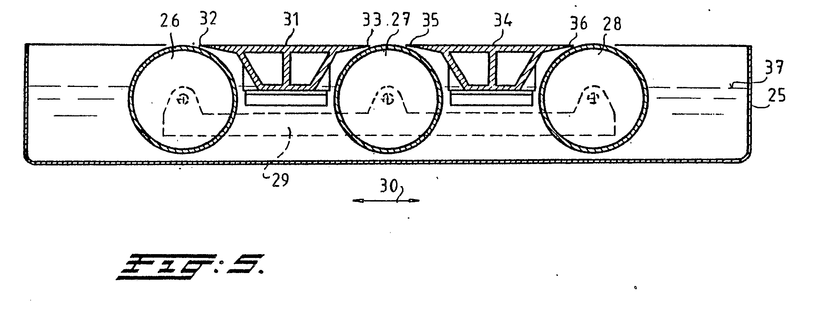

The source of radiation 7 is employed for image-wise exposing via the colour separation 6, the photoconductive coating after this latter has been charged up in the conventional manner; this charging up is undertaken by means of a corona device 8 (see fig. 2 and 3) which, when the frame 5 is tilted upwards, can be moved in the direction of the arrows 9 over the surface of the coating 3.

Underneath the support 2 and capable of movement in the direction of the arrows 10 there is a drum 11 on which is located the receptor sheet onto which the toner image has to be transferred.

On one side of the support 1, to the right in fig. 1, there is a set of four toner holders 13—16, accommodated in a frame 12 which is shown schematically, these being filled with toner of different colours. The frame 12 can move upwards and downwards in the direction of the arrows 17, whilst a certain selected toner holder, the top edge of which lies below the level of the lowest photoconductive coating, shown by the dashed line 18, can be brought out of the frame and can move to and fro along the bottom of this photoconductive coating in the direction shown by arrow 19 so as to supply toner to the photoconductive coating.

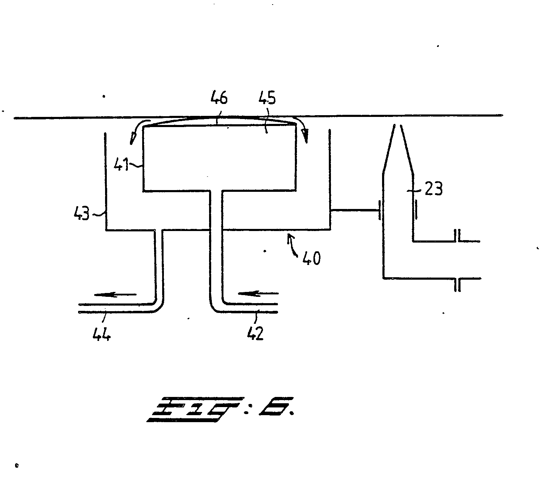

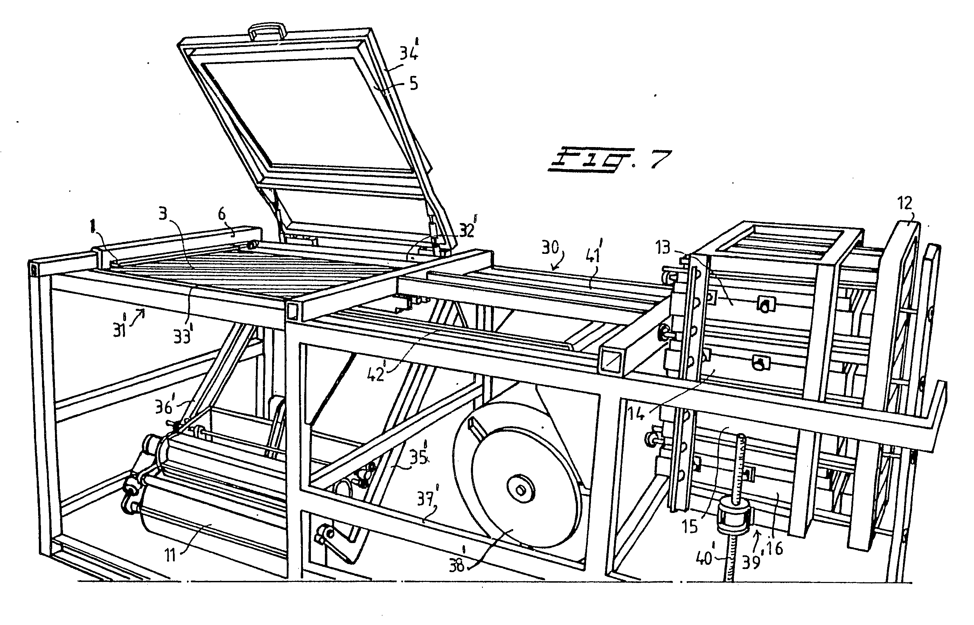

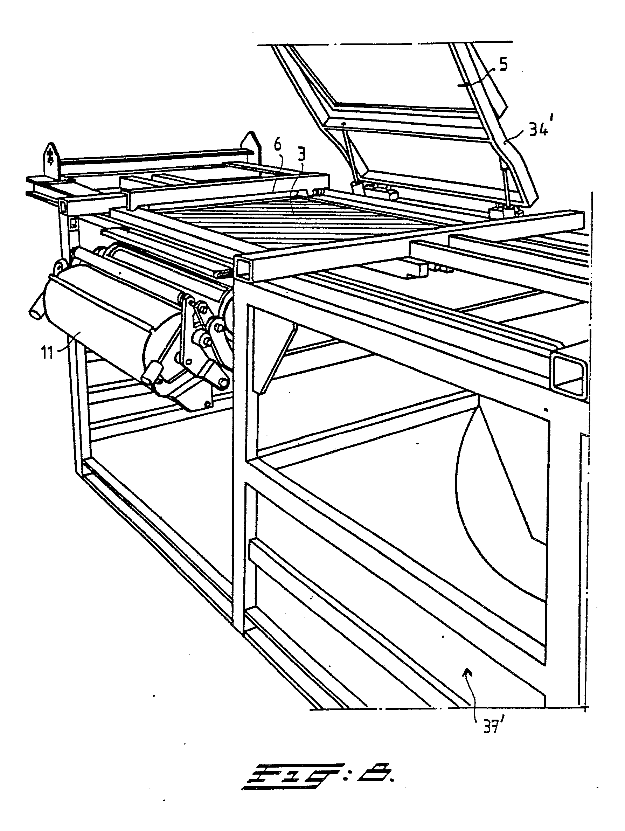

On the other side of the support 1, i.e. to the left in fig. 1, there is a device 20 for the removal of residual toner from the photoconductive coating; this device comprises a pair of rotary application rollers 22 mounted in a holder 21 which is filled with solvent, and a suction nozzle 23 arranged close thereto. These elements are combined with the toner solvent application device 40, which will be described in greater detail by reference to fig. 6, by means of which an accurately determined quantity of solvent is applied to the photoconductive coating.

The movement of the various components with respect to each other is illustrated by means of fig. 4a—4e. These illustrate a view which corresponds with that in fig. 1.

Let us begin with the components in the position illustrated in Fig. 4a. The exposure frame 5 is tilted upwards so that the corona arrangement 8 can be moved from left to right and back across the upper photoconductive surface 3. As result this surface is charged up to a predetermined potential; after this a colour separation 6 is placed on the surface and the frame 5 is closed, subject to a vacuum to ensure good contact, after which with the aid of the radiation source 7 the photoconductive coating 3 is image-wise exposed via the colour separation 6. Fig. 4b illustrates this stage of the process.

Subsequently frame 5 is tilted upwards, the colour separation 6 is removed and the support 1 is rotated through 180° around the shaft 2 which lies in the plane of the drawing. The coating 3 is now underneath and the coating 4 which has not yet been used is on top.

In the meantime the frame 12 together with toner carriages 13—16 has been brought to the correct height so that the toner carriage with toner of the desired colour (it is assumed that this for example is toner carriage 15) is located with its top edge level with the bottom edge of the coating 4. Toner carriage 14, the construction of which will be described in greater detail later, is removed from the frame 12 by means of a suitable drive arrangement and moved in the direction of arrow 19 along the bottom of the exposed photoconductive coating, on which there is now a latent charge image, so as to apply toner to the charged surface portions of the coating 3. This toner feed operation for all the partial images which have to be produced with the different colour separations, commences a certain period of time after the coating has been charged up to a predetermined final charge state which is mutually identical for all partial images. Since the characteristics of both coatings 3 and 4 are identical, image formation for all partial images takes place under mutually identical circumstances.

Coinciding with the development with toner of the image present on the coating 3, now the overlying coating 4 is charged up by means of the corona arrangement 8 to the same final charge state as employed previously for coating 3, preceding the image-wise exposure of this coating via a second colour separation. After the supply of toner the toner image formed on coating 3 must be transferred to a receptor substrate, in this case a sheet of paper present on drum 11 which for this purpose is placed close to the coating, after which the paper — not shown — is unrolled along the coating. During this operation a new colour separation 6', via which the coating 4 is exposed by means of the radiation source 7, is placed on the top coating 4.

After image transfer the drum 11 comes away from the bottom surface and the photoconductive coating 3 is cleaned to remove any residual toner by being washed with toner solvent. For this purpose use is made of the arrangement 20 with the two application brushes 22 arranged in rotary fashion in holder 21 and the suction nozzle 23 which like the rollers 22 extend across the entire length of the coating. The applied solvent is removed via the suction nozzle 23. Prior to being sucked away an accurately determined quantity of solvent is applied to the coating 3 by means of the arrangement 40 (see fig. 6).

Before cleaning the coating uniform exposure of the coating can also be undertaken by means of a light source, not shown, so as to cause any residual charge to flow away.

After this the support 1 is rotated around shaft 2 through 180° until it reaches the position illustrated in fig. 4a and can again be charged up and exposed. The coating 4 which now carries a charge pattern corresponding with the colour separation 6' is now located on the underside of the support 1 and is developed using toner of the desired second colour, after which this toner image is transferred to the substrate, in registration with the first toner image.

These operations are repeated with the other colour separations so that ultimately, for each of the basic colours and possibly black, a toner image is formed on the substrate by means of which the proof print is completed.

The horizontal position of the photoconductive coating during the various operations facilitates not only the operation of the device, especially the application of a colour separation onto the charged coating, but also the application of toner onto the charged coating and the cleaning thereof with solvent.

Fig. 5 shows a cross section of a preferred toner holder, indicated in its entirety in this diagram by the notation figure 25. The holder comprises three application rollers 26, 27 and 28, rotatably mounted in a frame 29, which is mounted in holder 25 so as to be capable of free movement to and fro over a short distance in the direction shown by arrow 30. Between the rollers 26 and 27 there is a plate 31, mounted in insulated fashion, with sharply tapered edges 32 and 33; between rollers 27 and 28 there in a similar plate 34 with sharply tapered edges 35 and 36 respectively.

Plates 31 and 34 which, as already stated, are arranged in insulated fashion with respect to the housing 25, can be connected with a voltage source of suitable potential and polarity, especially opposite to the toner polarity, so that during the development of the charge pattern by application of toner in the known manner a uniformly developed image is obtained.

During the movement of the holder 25 along the bottom of the photoconductive coating the frame 29 with rollers 26, 27 and 28 is shifted to such an extent that during movement towards the left the roller 26 will be located close to the edge 32 and the roller 27 will be close to the edge 35. During the return movement the roller 28 will be close to the edge 36 and the roller 27 close to the edge 33. As a result the distance between roller and edge is precisely governed so that an accurately predetermined quantity of toner, the level of which is indicated by the notation number 37, is applied to the charged coating.

Fig. 6 shows in a schematic section a device for applying an accurately determined quantity of toner carrier liquid to the coating, combined with the suction nozzle 23.

The toner carrier liquid feed arrangement 40 comprises an overflow chamber 41 connected to the toner carrier liquid feed pipe 42 and placed in a holder 43 to which a toner carrier liquid discharge pipe 44 is connected. The overflow chamber 41 will be filled completely with toner carrier liquid 45. This liquid has a .meniscus 46, the height of which depends on liquid characteristics and which is a constant for a certain liquid. Since the position of the photoconductive coating 3 during the various operations is fixed, by adjusting the spacing between the overflow chamber 41 with respect to this coating, the quantity of liquid which is fed to the coating can be governed extremely acurately.

The whole assembly is guided along the coating: the excess toner applied by rollers 26, 27, 28 is sucked away by the nozzle 23 and by means of the toner carrier liquid feed arrangement 40 the photoconductive coating is moistened to a predetermined extent; this during the return movement of the toner trolley. The object of this treatment is to prevent uncontrolled flows of toner particles along the photoconductive surface during the stage in which toner is transferred to the receptor medium.

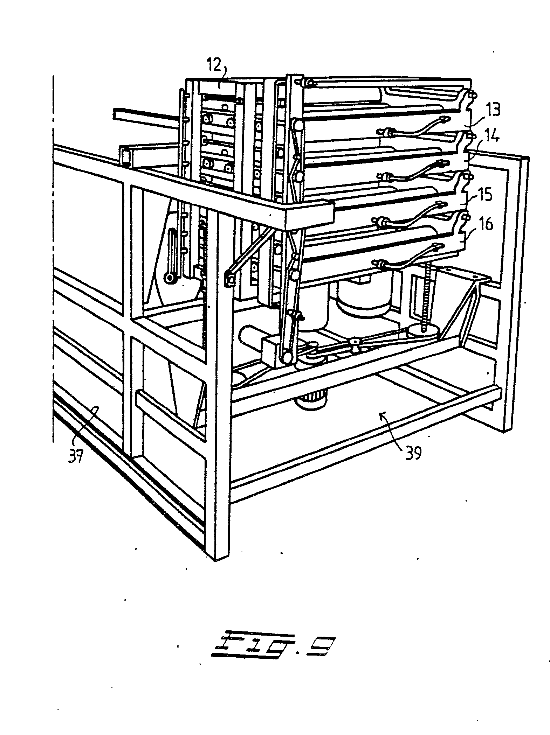

Fig. 7 gives a perspective view of part of the complete arrangement in accordance with the invention; fig. 8 provides a perspective view of the portion with the support and photoconductive coating, and fig. 9 a perspective view of the arrangement of the toner holders.

The cleaning unit 20 with rollers 22 and with a suction nozzle identical with 23 and an arrangement identical with 40 are visible in fig. 4a—4e. The cleaning rollers 22 function whilst going from left to right; during the return movement they are adjusted downwardly after which the suction nozzle and the fluid feed nozzle come into action. In fig. 7 the frame in which the entire assembly is accommodated is indicated by reference numeral 30. The left-hand portion 31 accommodates the support 1 with the photoconductive coating thereon visible. The corona arrangement 8 is similarly shown; this is guided past the guides 32', 33' and can be moved to and fro in the manner described previously across the coating 3. The frame 31' supports the pressure frame 5 accommodated in the tilting frame 34'. Underneath the support 1 is the drum 11 for taking up the material on which the representation is to be formed, the said drum being mounted on arms 35', 36'.

In the middle portion of the frame 37' different ancillary units are arranged such as a drum 38' which contains the various pipelines for fluid and the supply and discharge of medium required for normal operation; in the right-hand portion of the frame 39' a frame 12 with the four toner holders 13—16. This frame 12 can be moved upwards and downwards by means of the threaded spindle 40' and brought to the correct level.

After what has been stated above, fig. 8 requires no further explanation. Fig. 9 illustrates further details of the frame 12 with the four toner holders 13—16. The toner holder required can, guided in the guides 41', 42' of frame section 37' be brought in the manner described previously underneath the photoconductive coating.

## Claims

1. Method for forming a multi-colour proof print starting from at least two colour separations, wherein a charge pattern is formed from each colour separation by exposure of a photoconductive coating which has been charged previously to a certain charge state, this charge pattern being developed a predetermined period after the charge state has been achieved using toner of a colour corresponding to the colour separation concerned, the toner image thus obtained being transferred onto a receptor surface in such a way that the second and subsequent toner images are in registration with the preceding one(s), characterised in that use is made of at least two photoconductive coatings with identical characteristics and for each of the toner images a photoconductive coating is charged up to a final charge state and development with toner starts after a period of time after the coating has achieved the final charge state which period and final state are identical for all toner images.

2. Method as in claim 1, characterised in that the charging of the photoconductive coating is undertaken during a period which is identical for all the respective toner images under charging conditions which are identical for all partial images.

3. Method as in claim 1 and 2, characterised in that development by supply of toner is undertaken during a period which is identical for all toner images.

4. Method as in claims 2 and 3, characterised in that the charge and developing periods are mutually identical.

5. Method as in any one of claims 1 to 4, characterised in that use is made of several coatings with mutually identical characteristics for formation of the respective partial images.

6. Method as in claim 5, characterised in that the charging of a photoconductive coating is undertaken during the developing period of a coating which has already been charged up in advance and exposed with a partial image of another colour.

7. A method according to any one of claims 1 to 6, characterised in that when preparing a series of proof prints from the same original the exposures for a certain colour separation are effected with equal light quantities through the series.

8. A method according to any one of claims 1 to 7, characterised in that the photoconductive coating is moistened with a toner carrier liquid prior to the application of toner.

9. Method as in any one of claims 1 to 8, characterised in that after the transfer of the toner to the receptor surface and prior to the renewed charging of the photoconductive coating the surface thereof is moistened with a suitable solvent and the applied solvent is subsequently sucked off.

10. Method as in any one of claims 1 to 9, characterised in that after transfer of the toner to the receptor surface and prior to renewed charging the photoconductive coating is uniformly exposed.

11. Method as in any one of claims 1 to 10, characterised in that prior to toner transfer the receptor surface is moistened with toner carrier liquid and is dried after toner transfer.

12. Device for carrying out the method of any one of claims 1 to 11 comprising a housing which accommodates a flat support (1) for a photoconductive coating (3, 4), means to form a charge pattern from a colour separation by exposure of said coating charged previously, means (13—16) to develop the charge pattern a predetermined period after the charge state has been achieved using a tone of a colour corresponding to the colour separation concerned, means to transfer the toner image thus obtained onto a receptor surface (11) in such a way that the second and subsequent toner images are in registration with the preceding one(s), characterised in that means are provided to accommodate at least two photoconductive coatings (3, 4) having identical characteristics, that means are provided to charge up each of the photoconductive coatings for each of the toner images to a final charge state and to start development with toner after a period of time after the coatings (3, 4) have achieved the final charge state which period and final state are identical for all toner images.

13. Device as in claim 12, characterised in that the support can be moved around a fixed axis which is parallel with the surface, from an initial position in which the coating can be charged up and exposed to a second position which is rotated through 180° with respect thereto, in which the exposed surface can be provided with toner from one of the toner holders which are arranged one above the other in a magazine, which holders can for this purpose be brought by means of a drive mechanism from the magazine into a path which proceeds along the support and back into the magazine.

14. Device as in claim 13, characterised in that the support bears a photoconductive coating on both surfaces, the support is horizontal in both positions, the means of charging and exposure are located above the level of the support shaft, and the means of toner and image transfer are located thereunder.

15. Device as in any one of claims 12 to 14, characterised in that each toner holder is closed at the top face by a flat plate having at least two slots which are located transverse to the direction of movement of the holder, the slot level coinciding with that of the outer surface of a toner transport roller mounted in the holder, which roller can be driven in rotary fashion in a direction which is opposed to the direction of movement of the holder, and which during this rotation applies toner from the holder onto the plate.

16. Device as in claim 15, characterised in that the plate is arranged in electrically insulated fashion with respect to the support and, in order to function as developing electrode, can be brought to an electrical potential with respect to the support.

17. Device as in claims 15 and 16, characterised in that the rollers can be displaced over a short distance transverse to the axial direction thereof.

18. Device as in any one of claims 15 to 17, characterised in that this similarly comprises a doctor blade which, at least at the end of the toner application movements, ensures the cleaning of the flat top plate of the toner holders.

19. Device as in any one of claims 12 to 18, characterised by one or more solvent discharge and suction nozzles which pass over the width of the coating, having the discharge aperture facing upward, and accommodated in a frame which can move to and fro in àn essentially horizontal direction under the coating.

20. Device as in any one of claims 12 to 19, characterised by a holder for solvent which can move to and fro in a horizontal direction under the coating and by one or more application rollers which are driven in rotary fashion and which project over a short distance from the upper confine of the holder, coupled with a narrow overflow chamber which is open on top and which passes over the photoconductive coating, connected to a supply pipe for the solvent, incorporated in and projecting from a holder provided with a supply of liquid, which may be combined with a suction nozzle which passes over the photoconductive coating.

**Revendications**

1. Procédé pour la constitution d'une épreuve en plusieurs couleurs avec au moins deux images colorées partielles, dans lequel une image électrique est formée à partir de chaque support d'image colorée partielle, par exposition d'une couche photoconductrice qui a été chargée au préalable à un certain état, cette image électrique étant développée un certain laps de temps après que l'état de charge désiré a été atteint, en utilisant une substance révélatrice de là couleur correspondant à l'image colorée partielle concernée, l'image visible ainsi obtenue étant transférée sur une surface réceptrice de manière telle que la deuxième image visible, ainsi que les suivantes, soient en registre avec la (les) précédente(s), caractérisé en ce qu'on utilise au moins deux couches photoconductrices ayant des caractéristiques identiques et en ce que, pour chacune des images visibles, une couche photoconductrice soit chargée jusqu'à un état de charge final et que le développement à l'aide d'une substance révélatrice débute un certain laps de temps après que la couche a atteint l'état de charge final, ledit laps de temps et ledit état final étant identiques pour toutes les images visibles.

2. Procédé selon la revendication 1, caractérisé en ce que la charge de la couche photoconductrice s'effectue au cours d'une période qui est identique pour toutes les images visibles respectives, dans des conditions de charge qui sont identiques pour toutes les images partielles.

3. Procédé selon les revendications 1 et 2, caractérisé en ce que le développement à l'aide d'une substance révélatrice s'effectue au cours d'un laps de temps qui est identique pour toutes les images visibles.

4. Procédé selon les revendications 2 et 3, caractérisé en ce que les laps de temps de charge et déVéloppement sont identiques entre eux.

5. Procédé selon l'une des revendications 1 à 4, caractérisé en ce qu'on utilise plusieurs couches ayant des caractéristiques identiques pour la formation des images partielles respectives.

6. Procédé selon la revendication 5, caractérisé en ce que la charge de la couche photoconductrice s'effectue au cours du développement d'une couche qui a été préalablement chargée et exposée avec une image partielle d'une autre couleur.

7. Procédé selon l'une des revendications 1 à 6, caractérisé en ce que, lorsqu'on prépare l'impression d'une série d'épreuves à partir du même original, les expositions, pour une image colorée partielle déterminée, sont effectuées avec les mêmes quantités de lumière pour toute la série.

8. Procédé selon l'une des revendications 1 à 7, caractérisé en ce que la couche photoconductrice est humectée avec un liquide de support de la substance révélatrice avant d'appliquer la substance elle-même.

9. Procédé selon l'une des revendications 1 à 8, caractérisé en ce que, après transfert de la substance révélatrice sur la surface réceptrice et avant une nouvelle charge de la couche photoconductrice, la surface de cette dernière est humectée avec un solvant approprié et le solvant appliqué est ensuite enlevé par aspiration.

10. Procédé selon les revendications 1 à 9, caractérisé en ce que, après le transfert de la substance révélatrice sur la surface réceptrice et avant une nouvelle charge, la couche photoconductrice est uniformément exposée.

11. Procédé selon l'une des revendications 1 à 10, caractérisé en ce que, avant le transfert de la substance révélatrice, la surface réceptrice est humectée avec un liquide de support de la substance révélatrice et séchée après le transfert de cette substance.

12. Dispositif pour la mise en oeuvre du procédé selon l'une des revendications 1 à 11, comprenant un boîtier qui loge un support plat (1) d'une couche photoconductrice (3, 4), des moyens pour constituer une image électrique à partir d'une image colorée partielle, par exposition de ladite couche préalablement chargée, des moyens (13, 16) pour développer l'image électrique après un laps de temps prédéterminé une fois l'état de charge atteint, en utilisant une substance révélatrice de la couleur correspondant à l'image colorée partielle concernée, des moyens pour transférer l'image visible ainsi obtenue sur une surface réceptrice (11), de manière telle que la seconde image visible, ainsi que les images suivantes, soient en registre avec la (les précédente(s), caractérisé en ce qu'il est prévu des moyens pour recevoir au moins deux couches photoconductrices (3, 4) ayant des caractéristiques identiques, des moyens pour charger chacune des couches photoconductrices pour chacune des images visibles à un état de charge final et pour commencer le développement à l'aide d'une substance révélatrice un certain laps de temps après que l'état de charge final des couches (3, 4) a été atteint, ledit laps de temps et ledit état de charge étant identiques pour toutes les images visibles.

13. Dispositif selon la revendication 12, caractérisé en ce que le support peut être pivoté autour d'un axe fixe parallèle à la surface d'une position initiale où la couche peut être chargée à une deuxième position, basculée de 180° par rapport à la première, où une substance révélatrice peut être fournie à la surface exposée, cette substance provenant de récipients qui sont disposés, l'un au-dessus de l'autre, dans un conteneur, lesdits récipients pouvant à cet effet être extraits du conteneur et amenés sur une voie courant le long du support et revenant au conteneur, par un mécanisme d'entraînement.

14. Dispositif selon la revendication 13, caractérisé en ce que le support porte une couche photoconductrice sur ses deux faces, est horizontal dans ses deux positions, que les moyens pour la charge et l'exposition sont situés au-dessus du niveau de l'arbre du support et que les moyens de transfert de la substance révélatrice et de l'image sont situés en dessous de celui-ci.

15. Dispositif selon l'une des revendications 12 à 14, caractérisé en ce que chaque récipient à substance révélatrice est fermé sur le dessus par une plaque ayant au moins deux fentes transversales par rapport au sens de déplacement du récipient, le niveau des fentes coïncidant avec celui de la surface extérieure d'un rouleau de transport de la substance révélatrice disposé dans le récipient, ledit rouleau pouvant être entraîné en rotation en sens opposé au mouvement du récipient, et transmettant la substance révélatrice du récipient sur la plaque au cours de ce mouvement de rotation.

16. Dispositif selon la revendication 15, caractérisé en ce que la plaque est montée électriquement isolée par rapport au support et peut être amenée à un potentiel électrique par rapport au support, afin de servir d'électrode de développement.

17. Dispositif selon les revendications 15 et 16, caractérisé en ce que les rouleaux peuvent se déplacer sur une courte distance transversalement par rapport à leur axe.

18. Dispositif selon l'une des revendications 15 à 17, caractérisé en ce qu'il comprend, en outre, une raclette qui, au moins à la fin des déplacements servant à appliquer la substance révélatrice, procède au nettoyage de la plaque fermant le dessus des récipients à substance révélatrice.

19. Dispositif selon l'une des revendications 12 à 18, caractérisé par une ou plusieurs buses de distribution et d'aspiration qui balayent toute la largeur de la couche et dont l'ouverture de distribution débouche vers le haut, ces buses étant logées dans un bâti qui peut effectuer des mouvements de va-et-vient sensiblement horizontaux sous la couche.

20. Dispositif selon l'une des revendications 12 à 19, caractérisé par un récipient à substance révélatrice qui peut effectuer des mouvements horizontaux de va-et-vient sous la couche et par un ou plusieurs rouleaux d'application, entraînés en rotation, qui font légèrement saillie par rapport au bord supérieur du récipient, reliés à une chambre étroite de trop-plein qui est ouverte sur le haut, passe sur la couche photoconductrice et est reliée à un tuyau d'alimentation en solvant qui pénètre dans et fait saillie à partir d'un récipient contenant un liquide et qui peut être combiné avec une buse d'aspiration qui passe sur la couche photoconductrice.

**Patentansprüche**

1. Verfahren zum Herstellen eines mehrfarbigen Probedrucks, ausgehend von wenigstens zwei Farbauszügen, bei welchem durch Belichtung einer zuvor auf einen bestimmten Ladungszustand aufgeladenen Fotowiderstandsschicht von jedem Farbauszug ein Ladungsmuster gebildet wird, das Ladungsmuster eine vorbestimmte Zeitspanne nach Erreichen des Ladungszustands unter Verwendung eines Toners einer dem jeweiligen Farbauszug entsprechenden Farbe entwickelt wird und das dabei erhaltene Tonerbild derart auf eine Empfängerfläche übertragen wird, daß das zweite und weitere Tonerbilder mit dem oder den Voraufgegangenen in Deckung sind, dadurch gekennzeichnet, daß man wenigstens zwei Fotowiderstandsschichten mit identischen Eigenschaften verwendet und daß für jedes der Tonerbilder eine Fotowiderstandsschicht auf einen Ladungs-Endzustand aufgeladen wird und die Entwicklung mittels des Toners einer Zeitspanne nach Erreichen des Ladungs-Endzustands der Schicht beginnt, wobei die genannte Zeitspanne sowie der Endzustand für alle Tonerbilder identisch sind.

2. Verfahren nach Anspruch 1, dadurch gekennzeichnet, daß das Aufladen der Fotowiderstandsschicht während einer Zeitspanne erfolgt, welche für alle entsprechenden Tonerbilder identisch ist, und unter Ladebedingungen, welche für alle Teilbilder identisch sind.

3. Verfahren nach Anspruch 1 und 2, dadurch gekennzeichnet, daß die Entwicklung durch Zufuhr von Toner während einer Zeitspanne erfolgt, welche für alle Tonerbilder identisch ist.

4. Verfahren nach Anspruch 2 und 3, dadurch gekennzeichnet, daß die Zeitspannen für das Aufladen und das Entwickeln untereinander identisch sind.

5. Verfahren nach einem der Ansprüche 1 bis 4, dadurch gekennzeichnet, daß man für die Herstellung der entsprechenden Teilbilder mehrere Schichten mit untereinander identischen Eigenschaften verwendet.

6. Verfahren nach Anspruch 5, dadurch gekennzeichnet, daß das Aufladen einer Fotowiderstandsschicht während einer Zeitspanne erfolgt, während welcher eine zuvor bereits aufgeladene und mit einem Teilbild einer anderen Farbe belichtete Schicht entwickelt wird.

7. Verfahren nach einem der Ansprüche 1 bis 6, dadurch gekennzeichnet, daß bei Hestellung einer Reihe von Probedrucken vom gleichen Original die Belichtung für einen bestimmten Farbauszug in der gesamten Reihe mit gleichen Lichtmengen erfolgt.

8. Verfahren nach einem der Ansprüche 1 bis 7, dadurch gekennzeichnet, daß die Fotowiderstandsschicht vor der Aufbringung des Toners mit einer Toner-Trägerflüssigkeit befeuchtet wird.

9. Verfahren nach einem der Ansprüche 1 bis 8, dadurch gekennzeichnet, daß die Oberfläche der Fotowiderstandsschicht nach der Übertragung des Tonerbilds auf die Empfängerfläche und vor erneuter Aufladung der Fotowiderstandsschicht mit einem geeigneten Lösungsmittel befeuchtet und das aufgebrachte Lösungsmittel anschließend abgesaugt wird.

10. Verfahren nach einem der Ansprüche 1 bis 9, dadurch gekennzeichnet, daß die Fotowiderstandsschicht nach der Übertragung des Toners auf die Empfängerfläche und vor der erneuten Aufladung gleichmäßig belichtet wird.

11. Verfahren nach einem der Ansprüche 1 bis 10, dadurch gekennzeichnet, daß die Empfängerfläche for der Tonerübertragung mit Toner-Trägerflüssigkeit befeuchtet und nach der Tonerübertragung getrocknet wird.

12. Vorrichtung zum Durchführen des Verfahrens nach einem der Ansprüche 1 bis 11, mit einem Gehäuse, einer darin untergegrachten ebenen Auflage (1) für eine Fotowiderstandsschicht (3, 4) einer Einrichtung für die Bildung eines Ladungsmusters von einem Farbauszug durch Belichten der zuvor aufgeladenen Schicht, einer Einrichtung (13—16) zum Entwickeln des Ladungsmusters einer vorbestimmten Zeitspanne nach Erreichen des aufgeladenen Zustands unter Verwendung eines Toners von einer der des jeweiligen Farbauszugs entsprechenden Farbe und einer Einrichtung zum Übertragen des so erhaltenen Tonerbilds auf eine Empfängerfläche (11) in einer solchen Weise, daß das zweite und weitere Tonerbilder mit dem oder den Voraufgegangenen in Deckung sind, dadurch gekennzeichnet, daß Einrichtungen für die Aufnahme von wenigstens zwei Fotowiderstandsschichten (3, 4) mit identischen Eigenschaften vorgesehen sind, daß Einrichtungen zum Aufladen jeder Fotowiderstandsschicht auf einen Aufladungs-Endzustand für jedes der Tonerbilder und zum Beginnen der Entwicklung mittels des Toners um eine Zeitspanne nach Erreichen des Aufladungs-Endzustands der Schichten (3, 4) vorgesehen sind, wobei die genannte Zeitspanne sowie der Endzustand für alle Tonerbilder identisch sind.

13. Vorrichtung nach Anspruch 12, dadurch gekennzeichnet, daß die Auflage von einer Ausgangsstellung aus, in welcher die Schicht aufgeladen und belichtet werden kann, um eine zu ihrer Oberfläche parallele, feststehende Achse in eine um 180° dazu verdrehte zweite Stellung bewegbar ist, in welcher die belichtete Oberfläche mit Toner aus einem von mehreren übereinander in einem Magazin angeordneten Tonerbehältern beschickt werden kann, zu welchem Zweck die Behälter mittels eines Antriebs aus dem Magazin heraus entlang einer entlang der Auflage verlaufenen Bahn und zurück in das Magazin bewegbar sind.

14. Vorrichtung nach Anspruch 13, dadurch gekennzeichnet, daß die Auflage auf beiden Oberflächen eine Fotowiderstandsschicht trägt, daß die Auflage in beiden Stellungen waagerecht liegt, daß die Einrichtungen für die Aufladung und Belichtung oberhalb der Achse der Auflage angeordnet sind und daß die Einrichtungen für die Tonerbeschickung und -übertragung darunter angeordnet sind.

15. Vorrichtung nach einem der Ansprüche 12 bis 14, dadurch gekennzeichnet, daß jeder Tonerbehälter an der Oberseite durch einen ebenen Deckel abgeschlossen ist, welcher wenigstens zwei sich quer zur Bewegungsrichtung des Behälters erstreckende Schlitze aufweist, wobei das Niveau der Schlitze mit dem der Außenfläche einer im Behälter gelagerten Toner-Transportwalze koinzidiert, wobei die Walze unter Antrieb in der Bewegungsrichtung des Behälters entgegengesetzter Richtung in Drehung versetzbar ist und wobei die Walze bei ihrer Drehung Toner vom Behälter auf den Deckel aufbringt.

16. Vorrichtung nach Anspruch 15, dadurch gekennzeichnet, daß der Deckel der Auflage gegenüber elektrisch isoliert und gegenüber der Auflage auf ein elektrisches Potential bringbar ist, so daß er als Entwicklungselektrode wirksam ist.

17. Vorrichtung nach Anspruch 15 und 16, dadurch gekennzeichnet, daß die Walzen um ein kleines Stück quer zu ihrer Axialrichtung bewegbar sind.

18. Vorrichtung nach einem der Ansprüche 15 bis 17, dadurch gekennzeichnet, daß sie ein Wischerblatt aufweist, welches wenigstens am Ende der Tonerauftragsbewegungen die Reinigung des ebenen oberen Deckels der Tonerbehälter gewährleistet.

19. Vorrichtung nach einem der Ansprüche 12 bis 18, gekennzeichnet durch ein oder mehrere Lösungsmittel-Auftrags- und Absaugmundstücke, welche sich über die Breite der Schicht erstrecken, eine aufwärts ·gerichtete Austrittsöffnung aufweisen und in einem Rahmen untergebracht sind, welcher sich in einer im wesentlichen waagerechten Richtung unter der Schicht hin und her bewegen kann.

20. Vorrichtung nach einem der Ansprüche 12 bis 19, gekennzeichnet durch einen in einer waagerechten Richtung unter der Schicht hin und her bewegbaren Behälter für ein Lösungsmittel und durch eine oder mehrere von einem Antrieb in Drehung versetzbare Auftragswalzen, welche um ein kleines Stück über die Oberseite des Behälters hervorstehen, in Verbindung mit einer oben offenen, über die Fotowiderstandsschicht hinweg bewegbaren, schmalen Überlaufklammer, welche mit einer Zufuhrleitung für das Lösungsmittel verbunden, daraus hervorstehend in einem einen Flüssigkeitsvorrat enthaltenden Behälter angeordnet und gegebenenfalls mit einem Saugmundstück kombiniert ist, welches über die Fotowiderstandsschicht hinweg bewegbar ist.

Fig. 1.

Fig. 2.

Fig. 3.

FIG. 4.

Fig. 5.

Fig. 6.

Fig. 7

0 082 561

FIG. 8.

FIG.9